# EUROPEAN PATENT APPLICATION

(11) **EP 1 693 858 A1**
(43) Date of publication of application: **23.08.2006**
(21) Application number: 06250753.8
(22) Date of filing: 13.02.2006
(51) Int. Cl.: H01C 17/065

(54) **Thick film resistor, manufacturing method thereof, glass composition for thick film resistor and thick film resistor paste**

(30) Priority: 21.02.2005 JP 2005044642; 21.02.2005 JP 2005044652
(71) Applicant: TDK Corporation, Tokyo 103-8272 (JP)
(72) Inventor: Igarashi, Katsuhiko, Chuo-ku Tokyo 103-8272 (JP); Tanaka, Hirobumi, Chuo-ku Tokyo 103-8272 (JP)
(74) Representative: Wise, Stephen James

(57) **Abstract**

A thick film resistor includes glass containing a precious metal element and a conductive material dispersed in the glass. A method for manufacturing a thick film resistor includes the step of sintering a glass composition, a conductive material and resistor paste containing a precious metal element, with sintering conditions controlled, to melt the precious metal element in the glass. Another method for manufacturing a thick film resistor includes the step of sintering resistor paste containing a conductive material and a glass composition that contains a precious metal element. A glass composition includes 13 to 45 mol% of at least one member selected from the group consisting of CaO, SrO and BaO, 35 to 80 mol% of one or both of B₂O₃ and SiO₂, 0 to 11 mol% of one or both of ZrO₂ and Al₂O₃, 0 to 8 mol% of one or both of Ta₂O₅ and Nb₂O₅, 0 to 15 mol% of MnO and 0.1 to 10 mol% of a precious metal element. Thick film resistor paste contains at least the aforementioned glass composition and a conductive material and has the composition and material mixed with an organic vehicle.

## Description

### BACKGROUND OF THE INVENTION

### Field of the Invention:

The present invention relates to a thick film resistor having a conductive material dispersed in glass, particularly a novel thick film resistor having a precious metal element melted in glass, and a manufacturing method thereof. The invention relates also to a glass composition advantageously used for formation of a thick film resistor and further to thick film resistor paste using the glass composition.

### Description of the Prior Art:

In a thick film resistor formed by coating a substrate with thick film resistor paste including glass that is an insulating material and a conductive material and sintering the paste, ruthenium oxide (RuO₂), lead ruthenium composite oxide (Pb₂Ru₂O₆), etc. are generally used as the conductive material. As the glass, PbO-based glass is used. The glass acts as a bonding agent, and by variation in ratio between the conductive material and the glass the resistance value of the resistor can be adjusted.

In recent years, environmental issues have been much debated. It has been required that solder materials, for example, have to be deprived of lead. Thick film resistors cannot be regarded as an exception. When considering the environmental issues, therefore, both use of PbO-based glass and use of Pb₂Ru₂O₆ that is a conductive material have to be avoided. Under these circumstances, various studies have been made on lead-free thick film resistor paste that has glass and conductive materials to be used deprived of lead (refer to JP-A HEI 8-253342, JP-A HEI 10-224004, JP-A 2001-196201, JP-A HEI 11-251105 and Japanese Patent No. 3019136, for example).

However, these prior art references exhibit merely insufficient effects from the standpoint of provision of thick film resistors excellent in temperature characteristics (for example, the temperature coefficient of resistance (TCR)). The insufficient effect of each of the inventions disclosed in the prior art references is a matter of course because each invention does not aim at improving the temperature characteristics.

One of the issues raised when materializing lead-free thick film resistors is that the resistance value greatly fluctuates depending on the temperature to considerably deteriorate the temperature characteristics. The conductive material contained in a thick film resistor serves to shift the TCR to the plus (+) side and, as a result, the TCR value becomes large when seeing the thick film resistor as a whole to thereby deteriorate the temperature characteristics. This is problematic.

The present invention has been proposed in view of the actual state of affairs. One object of the present invention is to provide a thick film resistor excellent in temperature characteristics (TCR) and a manufacturing method thereof. Another object thereof is to provide a glass composition for a thick film resistor and thick film resistor paste both capable of forming a thick film resistor excellent in temperature characteristics (TCR).

To attain the above objects, the present inventors have made keen studies over a long period of time. As a result, he has acquired the knowledge that the TCR is specifically improved when a precious metal element is melted in glass constituting a thick film resistor. The present invention has been perfected based on this knowledge.

### SUMMARY OF THE INVENTION

The present invention provides a thick film resistor comprising glass containing a precious metal element and a conductive material dispersed in the glass.

In the thick film resistor, the precious metal element is at least one element selected from the group consisting of Ag and Pd. Though a precious metal element is generally contained as a conductive material in a thick film resistor, by melting the element in glass, the TCR in the thick film resistor can be improved to a great extent. Though the detailed reasons for this have not yet been made explicit, the improved TCR is the fact that has been confirmed by the present inventors through their experiments actually conducted.

The precious metal element can be melted in the glass using a glass composition, a conductive material and paste containing a precious metal element and sintering them to obtain a thick film resistor, with sintering conditions controlled. Otherwise, paste containing a conductive material and a glass composition having a precious metal element melted therein in advance may be sintered.

The present inventors have found out that the TCR can be improved to a great extent through reconsideration of the composition of a glass composition used in forming a thick film resistor.

The glass composition for a thick film resistor according to the present invention has been accomplished based on this knowledge. To be specific, the glass composition for a thick film resistor comprises 13 to 45 mol% of at least one member selected from the group consisting of CaO, SrO and BaO, 35 to 80 mol% of one or both of B₂O₃ and SiO₂, 0 to 11 mol% of one or both of ZrO₂ and Al₂O₃, 0 to 8 mol% of one or both of Ta₂O₅ and Nb₂O₅, 0 to 15 mol% of MnO and 0.1 to 10 mol% of the precious metal element.

The present invention further provides thick film resistor paste at least containing a glass composition and a conductive material and having them mixed with an organic vehicle, wherein the glass composition comprises 13 to 45 mol% of at least one member selected from the group consisting of CaO, SrO and BaO, 35 to 80 mol% of one or both of B₂O₃ and SiO₂, 0 to 11 mol% of one or both of ZrO₂ and Al₂O₃, 0 to 8 mol% of one or both of Ta₂O₅ and Nb₂O₅, 0 to 15 mol% of MnO and 0.1 to 10 mol% of a precious metal element.

The glass composition for a thick film resistor according to the present invention is characterized in that it contains a precious metal element, such as Ag and Pd. Though Ag and/or Pd is/are generally contained as a conductive material/materials in resistor paste, by having the Ag and/or Pd contained in a glass composition, the TCR in a resistor to be obtained is improved to a great extent.

Incidentally, it is speculated that each oxide contained in the glass composition is in the form not kept intact, but converted into a composite oxide, for example. In the present description, however, the content of each composition in the glass composition is shown in terms of each oxide so as to conform to customary practices. Strictly speaking, Ca is contained, not in the form of CaO, in the glass composition contained in the thick film resistor paste or in the thick film resistor. Also, Ca raw material is added in the form of CaCO₃ to the raw material composition. Therefore, "13 to 45 mol% of CaO content" means 13 to 45 mol% of Ca contained in terms of CaO in the composite oxide constituting the glass composition.

According to the present invention, it is possible to provide a thick film resistor excellent in temperature characteristics and highly reliable. Also, according to the present invention, it is possible to provide a glass composition and thick film resistor paste enabling a thick film resistor being obtained using them to have its TCR improved to a great extent. Therefore, it is possible to form a thick film resistor excellent in quality using the glass composition and the thick film resistor paste.

### DETAILED DESCRIPTION OF THE PREFERRED EMBODIMENT

A thick film resistor, its manufacturing method, a glass composition for the thick film resistor and thick film resistor paste using the glass composition according to the present invention will be described in detail herein below.

The thick film resistor according to the present invention is formed in the same manner as in the case of an ordinary thick film resistor by sintering (the seizure of) thick film resistor paste. The thick film resistor paste used contains a glass composition serving as an insulating material, a conductive material and optionally an additive, and has these components mixed with an organic vehicle.

From the standpoint of the environment conservation, as a prerequisite to the thick film resistor past, lead-free thick film resistor that contains substantially no lead is used. Therefore, it is premised that the glass composition or conductive material used contains substantially no lead. The term "substantially no lead" used herein means not containing lead in an amount exceeding the impurity level, the gist of which permits containing lead in an amount of the impurity level (around 0.05 mass% or less of lead in a glass composition, for example). There are cases where lead is contained in an extremely minute amount as an unavoidable impurity

The conductive material, when being dispersed in glass that is an insulating material, serves to impart conductivity to a thick film resistor that is a structural substance. The conductive material need not be particularly restricted, but preferably contains substantially no lead rather from the standpoint of the environment conservation. Concrete examples of the conductive material containing substantially no lead include, besides a ruthenium oxide, Ag-Pd alloy, Ag-Pt alloy, TaN, WC, LaB₆, MoSiO₂, TaSiO₂ and metals (Ag, Au, Pt, Cu, Ni, W, Mo, etc.). These materials can be used singly or in the form of a combination of two or more. Among others enumerated above, the ruthenium oxide is preferred. Concrete examples of the ruthenium oxide include, besides ruthenium oxides (RuO₂, RuO₄, etc.), ruthenium-based pyrochlores (Bi₂Ru₂O₇, Tl₂Ru₂O₇, etc.), ruthenium composite oxides (SrRuO₃, BaRuO₃, CaRuO₃, LaRuO₃, etc.), etc. Among others enumerated above, RuO₂, CaRuO₃, SrRuO₃, BaRuO₃ and Bi₂Ru₂O₇ are preferred.

The glass composition, when a thick film resistor containing it is formed, serves to bond a conductive material and an additive in the thick film resistor structure to a substrate. Any glass composition is optionally used similarly to the conductive material insofar as it contains substantially no lead. CaO-based glass, SrO-based glass and ZnO-based glass, for example, can advantageously be used.

As a concrete example of the CaO-based glass, Ca-B-Si-Zr(Al)-Ta(Nb)-O glass can be cited. The Ca-B-Si-Zr(Al)-Ta(Nb)-O glass contains CaO, SrO or BaO as a principal modified oxide, B₂O₃ or SiO₂ as a network-forming oxide, ZrO₂ or Al₂O₃ as a second modified oxide and Ta₂O₅ or Nb₂O₅ as a third modified oxide.

A Ca-B-Si-Mn-O glass composition can be cited as another example of the CaO-based glass. It contains CaO, B₂O₃, SiO₂ and MnO and has a composition ratio of, for example, 10 to 30 mol% of CaO, 25 to 40 mol% of B₂O₃, 15 to mol% of SiO₂ and 10to 40 mol% of MnO.

Any organic vehicle used for this kind of thick film resistor paste can be used and may be, for example, a mixture of a binder resin, such as ethyl cellulose, polyvinyl butyral, methacrylic resin, methacrylate, etc. with a solvent, such as terpineol, butyl carbitol, butyl carbitol acetate, toluene, various kinds of alcohols, xylene, etc. At this time, various kinds of dispersants, activations, plasticizers may appropriately be used together with the organic vehicle in accordance with the application etc. Various kinds of oxides, such as oxides of transition metal elements, typical metal elements, etc. may be added as the TCR adjusters or for other purposes.

The thick film resistor paste may further contain, besides the glass composition and conductive material, additives for the purpose of adjusting the resistance value and temperature characteristics or for other purposes. Examples of the additives include titanium compounds and metal oxides, for examples. These additives can appropriately be used selectively.

Particularly when at least one member selected from the group consisting of RuO₂, CaRuO₃, SrRuO₃, BaRuO₃ and Bi₂Ru₂O₇ is used as the conductive material, use of an alkaline earth metal titanate compound as a titanium compound enables the TCR to be improved to a great extent.

As the alkaline earth metal titanate compound, BaTiO₃, SrTiO₃, CaTiO₃, MgTiO₃, NiTiO₃, etc. can be cited. Preferably, these titanate compounds are selected depending on the resistance value and, in this case, it is preferable that the compositions thereof be optimized, respectively

As the metal oxide, use of one or a combination of two or more selected from the group consisting of V₂O₅, CuO, Cu₂O, ZnO, CoO, MnO₂ and Mn₃O₄ is effective. In particular, use of CuO, Cu₂O, etc. enables the Short Time OverLoad (STOL) to be further improved. Incidentally, the amount of CuO or Cu₂O to be added varies in optimum range depending on the resistance value and is preferred to be 0 to 5 mass% in a resistor composition for thick film resistor paste for the fabrication of a thick film resistor of 1 kΩ/□ to 10 MΩ/□ and 0 to 6 mass% in a resistor composition for thick film resistor paste for the fabrication of a thick film resistor of 0.1 kΩ/□ to 500 kΩ/□. Though these additives are added in the form of oxides, it is not always true that the additives are kept intact in the thick film resistor. There is a case where the additives exist in a glass composition in the form of solid solutions, for example.

The glass composition, conductive material and additives are mixed with the organic vehicle to prepare a mixture as thick film resistor paste. When the total mass of the glass composition, conductive material and additives is defined as 100, the ratio of the glass composition is preferably in the range of 10 to 55 mass%, that of the conductive material in the range of 35 to 80 mass% and that of the total additives in the range of 0.1 to 35 mass%.

When the ratio of the glass composition exceeds 55 mass% or that of the conductive material is less than 35 mass%, there is a possibility of a predetermined resistance value being not obtained and moreover the TCR of the temperature characteristics is shifted excessively to the minus (-) side to thereby deteriorate the temperature characteristics. Inversely, when the ratio of the glass composition is less than 10 mass% or that of the conductive material exceeds 80 mass%, the resistance value fluctuation or variation by aging becomes large, thus impairing the reliability.

With respect to the ratio of the organic vehicle to be added, the ratio (W2/W1) of the mass (W2) of the organic vehicle to the total mass (W1) of the glass composition, conductive material and additives is preferred to be 0.25 to 4 (W2:W1 = 1:0.25 to 1:4). More preferably, the ratio (W2/W1) is 0.5 to 2. When the ratio falls outside the above range, there is a possibility of thick film resistor paste that has viscosity suitable for forming a thick film resistor on a substrate, for example, being acquired.

The thick film resistor of the present invention can be formed by printing (applying) the thick film resistor paste containing the aforementioned components on a substrate, for example, by the screen printing or other such technique and sintering the paste at a temperature of around 850°C. As the substrate, a dielectric substrate, such as an Al₂O₃ substrate, BaTiO₃ substrate, etc.; a low-temperature co-fired ceramic substrate; an AlN substrate; etc. can be used. As regards the substrate mode, any of a single layer substrate, a composite substrate and a multilayer substrate can be adopted. In the case of the multilayer substrate, a thick film resistor may be formed on the surface or inside of the multilayer substrate.

When forming a thick film resistor, generally, a conductive pattern that will constitute an electrode is formed on a substrate. The conductive pattern can be formed through printing of conductive paste that contains a good conductive material, such as Ag-based alloy including Ag, Pt, Pd, etc., for example. In addition, the surface of the thick film conductor thus formed may be coated with a protective film (overglaze), such as a glass film, etc.

The thick film resistor of the present invention is formed by the procedure mentioned above. It is characterized greatly in that the glass composition contains a precious metal element, such as Ag, Pd, etc. By causing the glass composition to contain a precious metal, such as Ag, Pd, etc., the TCR is improved to a great extent. The content of the precious metal in the glass composition is preferred to be 10 mass% or less and exclude 0. While the addition of the precious metal in a relatively small amount manifests a large effect on the improvement in TCR, when the content of the precious metal element exceeds 10 mass%, the TCR may possibly be deteriorated.

In forming the thick film resistor of the present invention, therefore, a precious metal, such as Ag, Pd, etc. is added to the composition of the thick film resistor paste (glass composition, conductive material, additives and organic vehicle) and, at the same time, the sintering conditions, etc. are selected to cause the precious metal to be melted in the glass composition. The thick film resistor paste containing the precious metal is used and sintered to form a thick film resistor, with the amount of the precious metal to be added selected appropriately and the firing time, cooling rate, etc. during the sintering controlled. As a result, the glass composition contained in the structure of the thick film resistor thus formed comes to contain the precious metal in a prescribed amount.

The precious metal need not be melted all in the glass composition, but may partially be precipitated in the formed thick film resistor. In case where a precious metal is used for the conductive material, by melting part of the precious metal in the glass composition, it is possible for the glass composition contained in the thick film resistor to contain the precious metal in a prescribed amount.

Otherwise, a glass composition having a precious metal melted beforehand therein is used and resistor paste containing the glass composition and a conductive material is sintered to enable the thick film resistor according to the present invention to be formed.

In this case, a glass composition containing any one of CaO, SrO and BaO as s principal modified oxide component, B₂O₃ or SiO₂ as a network-forming oxide component, ZrO₂ or Al₂O₃ as a second modified oxide component and Ta₂O₅ or Nb₂O₅ as a third modified oxide component and a precious metal, such as Ag, Pd, etc. can be cited.

The contents of the components in the glass composition will be described. First, the content of the principal modified oxide component in the glass composition is preferably in the range of 13 mol% to 45 mol%. When the content falls short of the range, TCR, STOL, or other such characteristics may possibly be deteriorated. When the content exceeds the range, the modified oxide component is excessively precipitated when a thick film resistor has been manufactured to possibly deteriorate the characteristics and reliability thereof.

The content of B₂O₃ and SiO₂ that are network-forming oxide components in the glass composition is preferably in the range of 35 mol% to 80 mol%. The ratio of B₂O₃ and SiO₂ is optional. When the content falls short of the range, the softening point of the glass composition becomes high and, therefore, when a thick film resistor is formed at the prescribed firing temperature, the degree of sintering thereof will be insufficient to possibly deteriorate the reliability thereof. When the content exceeds the range, since the water resistance of the glass composition is lowered to possibly deteriorate the reliability of a thick film resistor being obtained.

The content of the second modified oxide component in the glass composition is preferably 11 mol% or less. When the content exceeds 11 mol%, metal oxides are excessively precipitated when a thick film resistor has been formed to possibly deteriorate the characteristics and reliability thereof.

The content of the third modified oxide component in the glass composition is preferably 8 mol% or less. When the content exceeds 8 mol%, the TCR, STOL or other such characteristics may possibly be deteriorated.

The glass composition may contain MnO in addition to the components mentioned above. When the glass composition contains MnO, it is possible to obtain a thick film resistor having a relatively small resistance value of around 1 kΩ/□. It is noted, however, that the content of MnO is preferably 15 mol% or less. When the content exceeds 15 mol%, there is a possibility of the TCR being adversely affected.

The glass composition contains a precious metal component in addition to the aforementioned oxide components. While an optional precious metal element can be used, Ag or Pd is highly effective. The content of the precious metal component in the glass composition is preferably in the range of 0.1 mol% to 10 mol%. The precious metal added in a relatively small amount manifests a great effect on the improvement in TCR. When the content exceeds 10 mol%, however, the TCR will possibly be deteriorated.

The precious metal element has to be dispersed in the glass composition not in the form of being precipitated, but in the form of being melted at the level of the element. Therefore, it is preferable that the precious metal is added as a raw material composition in preparing a glass composition. Of course, however, this is not limitative. For example, a precious metal component is added to a glass composition prepared from the aforementioned oxide components and the resultant mixture is melted by heat to enable the added precious metal component to be melted in the glass composition.

In summary, the glass composition comprises 13 to 45 mol% of at least one member selected from the group consisting of CaO, SrO and BaO, 35 to 80 mol% of one or both of B₂O₃ and SiO₂, 0 to 11 mol% of one or both of ZrO₂ and Al₂O₃, 0 to 8 mol% of one or both of Ta₂O₅ and Nb₂O₅, 0 to 15 mol% of MnO and 0.1 to 10 mol% of a precious metal element.

In the thick film resistor formed as described above, the precious metal element, such as Ag, Pd, etc., is melted in the glass composition to improve TCR to a great extent. Besides the precious metal melted in the glass composition, part thereof may exist in the thick film resistor in a precipitate state, with the result that the TCR is further improved.

The thick film resistor of the present invention having the aforementioned characteristic features is applicable to various kinds of electronic parts. Though the electronic parts are not particularly restricted, applicable examples are single-layer or multilayer circuit boards, electric parts including chip capacitors and inductors. In addition, it is applicable to electrode portions of capacitors, inductors, etc.

The preferred embodiments of the present invention will be described based on the results of the experiments conducted.

### Experiment 1:

A precious metal of Ag was added to thick film resistor paste and the precious metal (Ag) was melted in glass constituting a thick film resistor. To be specific, CaRuO₃ (a conductive material), CaO-based glass and the precious metal (Ag) were mixed with an organic vehicle to produce paste for a thick film resistor. The paste was printed on an alumina substrate in a prescribed shape and fired at 850°C for 10 minutes to 60 minutes to fabricate a plurality of thick film resistors having different contents of Ag in the pieces of glass. The ratio of CaRuO₃:CaO-based glass:Ag in the thick film resistor paste was set to be 20:68 to 79.9:0.1 to 12 (mass%). The content of Ag melted in the glass was controlled with variation of the firing time and cooling rate.

The Ag content in each glass, the resistance value and the TCR of each thick film resistor were measured. The results thereof are shown in Table 1 below. The Ag content in the glass was measured with the Transmission Electron Microscope-Energy Dispersive Spectrometer (TEM-EDS). The resistance value was measured with a measure having the product code of 34401A of Agilent Technologies. The mean value of the 24 samples was calculated. With respect to the TCR, the ratio of change in resistance value was obtained when changing the temperature to -55°C and to 125°C from room temperature of 25°C as the reference temperature. The value was the mean value of the 10 samples. When the resistance values at -55°C, 25°C and 125°C are defined as R-55, R25 and R125 (Ω/□), respectively, TCR (ppm/°C) = {(R-55 - R25)/R,25/80} x 1000000 or TCR (ppm/°C) = {(R125 - R25)/R25/100} x 1000000. Of the two, the higher value is regarded as a TCR value.

**Table 1**

| | | | | | | |
|---|---|---|---|---|---|---|
| Ag content in glass (mass%) | 0 | 0.5 | 3.4 | 5.9 | 9.7 | 11.2 |
| Resistance value (MΩ) | 0.89 | 0.944 | 1.79 | 3.51 | 10.5 | 33.6 |
| TCR (ppm/°C) | ±651 | ±209 | ±198 | ±154 | ±191 | ±490 |

As is clear from Table 1, the TCR is improved to a great extent in the case where Ag is melted in the glass in comparison with the case where no Ag is contained in the glass. When the Ag content in the glass exceeds 10 mass%, however, it is found that the effect of improving the TCR is lowered.

### Experiment 2:

Plural thick film resistors having different Ag contents were fabricated by following the procedure of Experiment 1 while changing the glass to SrO-based glass. The Ag content in each glass, the resistance value and the TCR of each thick film resistor were measured. The results thereof are shown in Table 2 below.

**Table 2**

| | | | | | | |
|---|---|---|---|---|---|---|
| Ag content in glass (mass%) | 0 | 0.2 | 3.0 | 5.1 | 8.9 | 12.0 |
| Resistance value (MQ) | 0.98 | 0.92 | 1.66 | 2.43 | 5.98 | 10.1 |
| TCR (ppm/°C) | ±678 | ±192 | ±156 | ±189 | ±201 | ±590 |

As is clear from Table 2, even when the glass is changed to SrO-based glass, the TCR is improved to a great extent in the case where Ag is melted in the glass in comparison with the case where no Ag is contained in the glass. When the Ag content in the glass exceeds 10 mass%, however, it is found that the effect of improving the TCR is lowered.

### Experiment 3:

Plural thick film resistors having different Ag contents were fabricated by following the procedure of Experiment 1 while changing the conductive material to SrRuO₃ and the glass to ZnO-based glass. The Ag content in each glass, the resistance value and the TCR of each thick film resistor were measured. The results thereof are shown in Table 3 below.

**Table 3**

| | | | | |
|---|---|---|---|---|
| Ag content in glass (mass%) | 0 | 0.1 | 2.2 | 3.9 |
| Resistance value (MΩ) | 1.89 | 5.53 | 6.89 | 8.22 |
| TCR (ppm/°C) | ±865 | ±277 | ±289 | ±221 |

As is clear from Table 3, also in Experiment 3, the TCR is improved to a great extent in the case where Ag is melted in the glass in comparison with the case where no Ag is contained in the glass.

### Experiment 4:

Plural thick film resistors having different Ag contents were fabricated by following the procedure of Experiment 1 while changing the conductive material to SrRuO₃, the glass to SrO-based glass and the precious metal element to Pd. The Pd content in each glass, the resistance value and the TCR of each thick film resistor were measured. The results thereof are shown in Table 4 below.

**Table 4**

| | | | | |
|---|---|---|---|---|
| Pd content in glass (mass%) | 0 | 0.3 | 3.9 | 6.2 |
| Resistance value (MΩ) | 1.11 | 1.31 | 7.45 | 10.13 |
| TCR (ppm/°C) | ±682 | ±221 | ±200 | ±187 |

As is clear from Table 4, also in Experiment 4, the TCR is improved to a great extent in the case where Pd is melted in the glass in comparison with the case where no Pd is contained in the glass.

### Experiment 5:

Plural thick film resistors having different Ag contents were fabricated, with the Ag melted in glass and existing in the thick film resistors in a precipitated state, on condition that the ratio of CaRuO₃:CaO-based glass:Ag in the thick film resistor paste was set to be 20:75 to 79.5:0.5 to 5 (mass%). The amounts of the Ag melted and precipitated were controlled with variation of the firing time and cooling rate. The Ag content in each glass, the precipitated Ag content (Ag content in the resistor), the resistance value and the TCR of each thick film resistor were measured. The results thereof are shown in Table 5 below.

**Table 5**

| | | | |
|---|---|---|---|
| Amount ofAg added (mass%) | 0.5 | 3 | 5 |
| Ag content in glass (mass%) | 0.2 | 1.8 | 3.9 |
| Ag content in resistor (mass%) | 0.3 | 1.2 | 1.1 |
| Resistance value (MΩ) | 0.75 | 1.9 | 1.81 |
| TCR (ppm/°C) | ±89 | ±101 | ±93 |

As is clear from Table 5, by melting Ag in the glass and by allowing Ag to exist in the thick film resistor in the precipitated state, the effect of further improving the TCR can be acquired.

### Experiment 6:

In this experiment, thick film resistor paste was prepared using a glass composition having a precious metal element (Ag) melted beforehand therein, and thick film resistors were fabricated using the thick film resistor paste. Glass compositions were first prepared. As materials for the glass compositions, CaCO₃, B₂O₃, SiO₂, ZrO₂, Al₂O₃, Ta₂O₅, Nb₂O₅, MnCO₃ and Ag were used. From these components prescribed components were selected and weighed out in respectively prescribed amounts. The resultant components were introduced into a platinum crucible and melted at 1350°C for one hour. The resultant melt was introduced into water to quench it, thereby obtaining a glass product. The glass product was wet-pulverized using a ball mill to obtain glass compositions 1 to 21. The compositions of the thus obtained glass compositions are shown in Table 6 below. Incidentally, in the compositions shown in Table 6, the numerical values indicate the rates of the components (mol%). The values marked with * fall outside the optimum range.

**Table 6**

| Glass composition No. | CaO | B₂O₃ | SiO₂ | ZrO₂ | Al₂O₃ | Ta₂O₅ | Nb₂O₅ | Ag | MnO |
|---|---|---|---|---|---|---|---|---|---|
| 1 | *10 | 46 | 32 | 5 | - | 2 | - | 5 | - |
| 2 | *50 | 23 | 15 | 5 | - | 2 | - | 5 | - |
| 3 | 15 | *49 | *33 | 1 | - | 1 | - | 1 | - |
| 4 | 45 | *18 | *12 | 5 | - | 5 | - | 5 | - |
| 5 | 30 | 30 | 21 | *12 | - | 2 | - | 5 | - |
| 6 | 30 | 30 | 21 | 5 | - | *9 | - | 5 | - |
| 7 | 30 | 36 | 24 | 5 | - | 5 | - | *0 | - |
| 8 | 30 | 29 | 19 | 5 | - | 5 | - | *12 | - |
| 9 | 20 | 35 | 20 | 0 | - | 0 | - | 5 | *20 |
| 10 | 13 | 45 | 30 | 5 | - | 2 | - | 5 | - |
| 11 | 45 | 25 | 18 | 5 | - | 2 | - | 5 | - |
| 12 | 45 | 21 | 14 | 6 | - | 8 | - | 6 | - |
| 13 | 17 | 48 | 32 | 1 | - | 1 | - | 1 | - |
| 14 | 30 | 38.3 | 25.6 | 5 | - | 1 | - | 0.1 | - |
| 15 | 30 | 32 | 22 | 5 | - | 1 | - | 10 | - |
| 16 | 28 | 38 | 25 | 5 | - | 1 | - | 3 | - |
| 17 | 20 | 36 | 24 | 0 | - | 0 | - | 5 | 15 |
| 18 | 13 | 45 | 30 | 5 | - | - | 2 | 5 | - |
| 19 | 30 | 32 | 22 | 5 | - | - | 1 | 10 | - |
| 20 | 13 | 45 | 30 | - | 5 | - | 2 | 5 | - |
| 21 | 13 | 45 | 30 | 3 | - | - | 2 | 5 | 2 |

Thick film resistors (sample 1 to sample 23) were fabricated using the glass compositions shown in Table 6. The characteristics (resistance value, TCR) of each thick film resistor were evaluated. The results of the evaluation are shown in Table 7 below. The samples marked with * in Table 7 indicate that any one of the compositions of the components of the glass compositions falls outside the optimum range.

**Table 7**

| Sample No. | Glass composition | Conductive material | R(kΩ) | TCR (ppm/°C) |
|---|---|---|---|---|
| *1 | 1 | CaRuO₃ | 112 | ±565 |
| *2 | 2 | CaRuO₃ | 785 | ±452 |
| *3 | 3 | CaRuO₃ | 65 | ±781 |
| *4 | 4 | CaRuO₃ | 490 | ±609 |
| *5 | 5 | CaRuO₃ | 2043 | ±893 |
| *6 | 6 | CaRuO₃ | 1243 | ±420 |
| *7 | 7 | CaRuO₃ | 900 | ±609 |
| *8 | 8 | CaRuO₃ | 5009 | ±887 |
| *9 | 9 | CaRuO₃ | 5 | ±890 |
| 10 | 10 | CaRuO₃ | 78 | ±112 |
| 11 | 11 | CaRuO₃ | 672 | ±187 |
| 12 | 12 | CaRuO₃ | 2390 | ±200 |
| 13 | 13 | CaRuO₃ | 36 | ±112 |
| 14 | 14 | CaRuO₃ | 109 | ±149 |
| 15 | 15 | CaRuO₃ | 4091 | ±209 |
| 16 | 16 | CaRuO₃ | 409 | ±155 |
| 17 | 17 | CaRuO₃ | 12 | ±139 |
| 18 | 18 | CaRuO₃ | 111 | ±126 |
| 19 | 19 | CaRuO₃ | 5108 | ±176 |
| 20 | 20 | CaRuO₃ | 85 | ±187 |
| 21 | 21 | CaRuO₃ | 85 | ±187 |
| 22 | 16 | SrRuO₃ | 423 | ±198 |
| 23 | 17 | RuO₂ | 1 | ±154 |

As is clear from Table 7, in each of samples 10 to 23 having Ag melted beforehand in the glass composition to optimize the glass composition, the TCR is greatly improved.

### Experiment 7:

Thick film resistors (samples 24 to 28) were fabricated by following the procedure of Experiment 6, using glass composition 16 in Table 6 and selecting additives from BaTiO₃, SrTiO₃, CuO and Cu₂O. The compositions of the resistor paste and the results of evaluation of the characteristics are shown in Table 8 below, from which it is found that the addition of the additives enables the TCR to be further improved.

**Table 8**

| Sample No. | Composition of thick film resistor paste | R (kΩ) | TCR (ppm/°C) |
|---|---|---|---|
| 24 | CaRuO₃:Glass composition 16:BaTiO₃ =20:75:5 (mass%) | 765 | ±89 |
| 25 | SrRuO₃:Glass composition 16:BaTiO₃ =20:75:5 (mass%) | 771 | ±87 |
| 26 | CaRuO₃:Glass composition 16:SrTi O₃ = 20:75:5 (mass%) | 721 | ±88 |
| 27 | CaRuO₃:Glass composition 16:BaTiO₃:CuO = 20:73:5:2 (mass%) | 507 | ±35 |
| 28 | CaRuO₃:Glass composition 16: BaTiO₃:Cu₂O = 20:73:5:2 (mass%) | 573 | ±40 |

## Claims

1. A thick film resistor comprising glass containing a precious metal element and a conductive material dispersed in the glass.

2. A thick film resistor according to claim 1, wherein the glass has a precious metal element content that is 10 mass% or less and excludes 0.

3. A thick film resistor according to claim 1, wherein the precious metal element comprises at least one element selected from the group consisting of Ag and Pd.

4. A thick film resistor according to claim 1, wherein the precious metal element contained in the glass includes one existing in a precipitated state in the glass.

5. A thick film resistor according to claim 1, wherein the conductive material comprises at least one member selected from the group consisting of CaRuO₃, BaRuO₃, SrRuO₃, Bi₂Ru₂O₇ and RuO₂.

6. A thick film resistor according to claim 1, wherein the glass composition comprises 13 to 45 mol% of at least one member selected from the group consisting of CaO, SrO and BaO, 35 to 80 mol% of one or both of B₂O₃ and SiO₂, 0 to 11 mol% of one or both of ZrO₂ and Al₂O₃, 0 to 8 mol% of one or both of Ta₂O₅ and Nb₂O₅, 0 to 15 mol% of MnO and 0.1 to 10 mol% of the precious metal element.

7. A method for manufacturing a thick film resistor, comprising the step of sintering a glass composition, a conductive material and resistor paste containing a precious metal element, with sintering conditions controlled, to melt the precious metal element in the glass.

8. A method for manufacturing a thick film resistor, comprising the step of sintering resistor paste containing a conductive material and a glass composition that contains a precious metal element.

9. A glass composition for thick film resistor comprising 13 to 45 mol% of at least one member selected from the group consisting of CaO, SrO and BaO, 35 to 80 mol% of one or both of B₂O₃ and SiO₂, 0 to 11 mol% of one or both of ZrO₂ and Al₂O₃, 0 to 8 mol% of one or both of Ta₂O₅ and Nb₂O₅, 0 to 15 mol% of MnO and 0.1 to 10 mol% of a precious metal element.

10. A glass composition for thick film resistor according to claim 9, wherein the precious metal element comprises at least one element selected from the group consisting of Ag and Pd.

11. Thick film resistor paste containing at least a glass composition and a conductive material and having the glass composition and conductive material mixed with an organic vehicle, wherein the glass composition comprises 13 to 45 mol% of at least one member selected from the group consisting of CaO, SrO and BaO, 35 to 80 mol% of one or both of B₂O₃ and SiO₂, 0 to 11 mol% of one or both of ZrO₂ and Al₂O₃, 0 to 8 mol% of one or both of Ta₂O₅ and Nb₂O₅, 0 to 15 mol% of MnO and 0.1 to 10 mol% of a precious metal element.

12. Thick film resistor paste according to claim 11, wherein the precious metal element comprises at least one element selected from the group consisting of Ag and Pd.

13. Thick film resistor paste according to claim 11, wherein the conductive material comprises at least one member selected from the group consisting of CaRuO₃, BaRuO₃, SrRuO₃, Bi₂Ru₂O₇ and RuO₂.

14. Thick film resistor paste according to claim 11, further comprising a titanium compound as an additive.

15. Thick film resistor paste according to claim 14, wherein the titanium compound comprises at least one compound selected from the group consisting of BaTiO₃, SrTiO₃, CaTiO₃, MgTiO₃, CoTiO₃ and NiTiO₃.

16. Thick film resistor paste according to claim 11, further comprising CuO or Cu₂O as an additive.
